# EUROPÄISCHE PATENTSCHRIFT

(11) **EP 2 491 632 B1**
(45) Veröffentlichungstag und Bekanntmachung des Hinweises auf die Patenterteilung: **26.07.2017**
(21) Anmeldenummer: 10762933.9
(22) Anmeldetag: 08.10.2010
(51) Int. Cl.: H02J 7/00, G01R 31/36, B60L 11/18

(54) **VERFAHREN ZUR PRÄZISEN LEISTUNGSVORHERSAGE FÜR BATTERIEPACKS**
METHOD FOR PRECISION POWER PREDICTION FOR BATTERY PACKS
PROCÉDÉ DE PRÉDICTION PRÉCISE DE LA PRÉDICTION DE PERFORMANCE D'UN BLOC-BATTERIE

(30) Priorität: 19.10.2009 DE 102009045783
(43) Veröffentlichungstag der Anmeldung: 29.08.2012
(73) Patentinhaber: Robert Bosch GmbH, 70442 Stuttgart (DE)
(72) Erfinder: BOEHM, Andre, 70806 Kornwestheim (DE)
(86) Internationale Anmeldenummer: PCT/EP2010/065138
(87) Internationale Veröffentlichungsnummer: WO 2011/047978

(56) Entgegenhaltungen:
- EP-A1- 1 941 290
- DE-A1- 10 203 810
- US-A1- 2005 110 498

## Beschreibung

### Technisches Gebiet

Die Erfindung betrifft eine Vorrichtung und ein Verfahren zur Erfassung des Betriebszustands eines Akkumulatorsystems, das zur Traktion eines Fahrzeugs verwendet wird. Insbesondere betrifft die Erfindung ein Verfahren und eine Vorrichtung zur Ermittlung der maximal abrufbaren Leistung eines Akkumulatorsystems.

### Stand der Technik

Für Hybridfahrzeuge oder Elektrofahrzeuge werden in Serie geschaltete Akkumulatorelemente verwendet, deren Gesamtspannung zur Traktion des Fahrzeugs mittels eines Elektromotors verwendet wird. Von derartigen seriellen Akkumulatorsystemen ist bekannt, dass beispielsweise aufgrund unterschiedlicher Innenwiderstände einzelne Akkumulatorelemente stärker belastet werden als andere und somit einem schnelleren Alterungsprozess unterliegen. Ferner ist bekannt, dass durch die Serienschaltung die bereits geschwächten Akkumulatorelemente durch die Serienschaltung einer stärkeren Belastung unterworfen sind.

Der Gesamtzustand wird ermittelt, indem die jeweiligen Zellenspannungen sowie der Gesamtstrom des Akkumulatorsystems erfasst wird, um zusammen mit der erfassten Temperatur der einzelnen Akkumulatorelemente auf einen jeweiligen Zustand der einzelnen Akkumulatorelemente zu schließen. Der Zustand kann insbesondere mittels Modellen dargestellt werden, wobei die Modelle Messdaten wie Temperatur, Zellspannung und Zellstrom erhalten, und aufgrund von Akkumulatoreigenschaften, die von dem Modell simuliert werden, das Modell einen Ladezustand, einen aktuellen Widerstand oder eine aktuelle Kapazität vorsehen kann. Hierzu kann das Modell interne Größen verwenden, beispielsweise interne Zustände der Akkumulatorelemente wie Konzentrationen, innere Temperaturen oder deren Verteilungen, oder Ladezustand oder nutzbare Kapazität.

Um beispielsweise die noch verbleibende Reichweite eines Fahrzeugs zu ermitteln, das mit einem derartigen Akkumulatorsystem betrieben wird, wird gemäß dem Stand der Technik die Summe aller Zustände der einzelnen Akkumulatorelemente verwendet, um auf die noch verbleibende Energie schließen zu können, die von dem Akkumulatorsystem insgesamt aufgebracht werden kann. Hierbei ist es üblich, dass die einzelnen Zustandsparameter aller Elemente miteinander gleichermaßen kombiniert werden, d.h. gemittelt werden oder durch eine Summe vorgesehen werden, die die noch verbleibende Traktionsenergie oder andere Zustandsparameter des gesamten Akkumulatorsystem angibt. Aus diesen gemittelten bzw. summierten Daten aller Akkumulatorelemente wird beispielsweise auch eine noch maximal abrufbare Leistung des Akkumulatorsystems berechnet.

Zum einen ist hierzu erforderlich, dass die Zustandsparameter jeder einzelnen Zelle berechnet werden, wobei dadurch eine Vielzahl von Instanzen des zugrunde liegenden Modells vorgesehen werden müssen und mit individuellen Messdaten versorgt werden müssen. Zum anderen werden durch die Mittelung nicht alle für das Akkumulatorsystem wichtigen Zustände erfasst, insbesondere werden schwache Akkumulatorelemente gleichermaßen behandelt wie starke Akkumulatorelemente.

Daher geben bisherige Verfahren zur Erfassung einer maximal abrufbaren Leistung nicht alle Zustände des Akkumulatorsystems wieder. Ferner erfordert der Stand der Technik eine sehr aufwändige Berechnung, die für alle Elemente gleichermaßen eine individuelle Zustandsüberwachung/Zustandsverfolgung vorsieht. Zudem werden bereits geschwächte Zellen weiterhin überdurchschnittlich belastet. Die US 2005/0110498 A1 offenbart die Berechnung einer maximal abrufbaren Leistung, durch Ermittlung des maximal zulässigen Stroms für eine Batterie mit mehreren in Serie geschalteten Zellen und anschließende Multiplikation dieses Wertes mit der jeweilige Zellspannung zu einem zukünftigen Zeitpunkt.

Die DE 10 2005 050 563 A1 offenbart die Berechnung einer maximal abrufbaren Leistung eines Akkumulators anhand eines mathematischen Modells für einen Blei-Akkumulator, mithilfe dessen der SOC-Wert ermittelt wird. Auf Basis des SOC-Wertes wird die zur Verfügung stehende Entladeleistung über ein Prädiktionsmodell ermittelt.

Die DE 102 03 810 A1 offenbart die Ermittlung der Leistungsfähigkeit eines Blei-Akkumulators anhand der Verwendung der Ruhespannung und des ermittelten Wertes für den Innenwiderstand des Akkumulators.

Es ist daher eine Aufgabe der Erfindung, einen vereinfachten Mechanismus zur Erfassung der Zustände eines Akkumulatorsystems vorzusehen, wobei gleichzeitig die dargestellten Zustände die aktuellen Eigenschaften des Akkumulatorsystems präziser wiedergeben.

### Offenbarung der Erfindung

Diese Erfindung wird gelöst durch das Verfahren nach Anspruch 1 und die Vorrichtung nach Anspruch 7. Weitere erfindungsgemäße Ausgestaltungen werden durch die abhängigen Ansprüche offenbart. Der Erfindung liegt die Fragestellung zugrunde, ob durch Mittelung der einzelnen Zustände das Gesamtsystem mit allen wichtigen Eigenschaften wiedergegeben ist. Insbesondere liegt der Erfindung die Fragestellung zugrunde, ob ein überdurchschnittlich leistungsfähiges Akkumulatorelement über die gemittelte Zustandserfassung ein unterdurchschnittliches Akkumulatorelement in jedem Fall kompensieren kann, soweit die Beträge gleichermaßen von einem Mittelwert abweichen. Das sich daraus ergebende Konzept der Erfindung ist es, leistungsschwache Akkumulatoren besonders zu berücksichtigen, da diese durch besonders starke Entladung Schaden nehmen und stark altern. Dieser Effekt lässt sich nicht kompensieren durch ein anderes überdurchschnittlich leistungsfähiges Akkumulatorelement. Erfindungsgemäß wird zur Ermittlung der maximal abrufbaren Leistung (welche im Weiteren während des Betriebs als Belastungsgrenze des gesamten Systems dient) das schwächste (oder die schwächsten) Akkumulatorelemente dadurch geschützt, dass die maximal abrufbare Leistung anhand der maximalen Leistung des schwächsten Elements berechnet wird. Daher führt die Belastung des Gesamtsystems gemäß dieser Berechnung zu einer Einzelbelastung des schwächsten Elements, welche das schwächste Akkumulatorelement nicht schädigt. Im Gegensatz hierzu wird beim Stand der Technik ein Mittelwert verwendet, bei dem gewährleistet ist, dass die meisten Akkumulatorelemente nicht auf schädigende Art belastet werden, wobei jedoch zumindest das leistungsschwächste Element aufgrund der Orientierung am Mittelwert übermäßig stark belastet wird und dadurch stark altert. Diese Alterung beeinträchtigt die Leistung des Gesamtsystems.

Anhand dieser Gegenüberstellung ist zu erkennen, dass die maximal abrufbare Leistung gemäß der Erfindung präziser vorgesehen werden kann, da auch Alterungsprozesse (die zu vermeiden sind) berücksichtigt werden, wodurch die Vorhersage der Leistungsfähigkeit des Traktions-Akkumulatorsystems präziser ist. Insbesondere wird dadurch berücksichtigt, dass eine übermäßige Alterung eines einzelnen Elements nicht nur dieses Element betrifft, sondern gegebenenfalls das gesamte System stören kann, wobei eine durch Mittelung der Zustände vorgesehene Leistungsangabe eine derartige Störung nicht berücksichtigt. Da sich durch die erfindungsgemäß präzisere Darstellung der maximal abrufbaren Leistung der weitere Betrieb nach dieser Leistung richten kann und somit das schwächste Element soweit wie möglich schont, ergibt sich durch das erfindungsgemäße Verfahren und die erfindungsgemäße Vorrichtung eine wesentliche Erhöhung der Lebensdauer des Akkumulatorsystems. Somit wird die Lebensdauer des Akkumulatorsystems erhöht, wenn die erfindungsgemäß vorgesehene maximal abrufbare Leistung, die sich am schwächsten Element orientiert, für den Betrieb des Akkumulatorsystems verwendet wird.

Da das schwächste bzw. die schwächsten Akkumulatorelemente die maximal abrufbare Leistung wesentlich bestimmen, ist lediglich eine präzise Modellierung der Zustände nur dieser Elemente notwendig. Da aufgrund der Serienschaltung auch die anderen Akkumulatorelemente an die Leistungsabgabegrenze der schwächsten Akkumulatorelemente (oder des schwächsten Akkumulatorelements) gebunden sind, müssen diese Akkumulatorelemente nicht über ein Modell überwacht werden, sondern es wird eine einfache Extrapolation der Gesamtleistung anhand der Leistungsabgabegrenze für die schwächsten Akkumulatorelemente vorgesehen. Damit sind lediglich Berechnungen zu dem schwächsten Akkumulatorelement notwendig, wobei die Extrapolation ohne wesentliche Verschlechterung der Präzision anhand des Zustands des schwächsten Akkumulatorelements die maximal abrufbare Leistung des gesamten Traktions-Akkumulatorsystems vorsieht. Es wird daher ein Verfahren zur Ermittlung der maximal abrufbaren Leistung eines Traktions-Akkumulatorsystems vorgesehen, das eine Vielzahl in Serienschaltung vorgesehener Akkumulatorelemente umfasst. Das Traktions-Akkumulatorsystem kann insbesondere ein System sein, das im Antrieb eines Elektrofahrzeugs oder Hybridfahrzeugs verwendet wird.

Das Verfahren sieht vor, mindestens einen Leistungsindikator für jedes Akkumulatorelement vorzusehen. Aufgrund dieses Leistungsindikators kann das schwächste Akkumulatorelement (oder die schwächsten Akkumulatorelemente) erfasst werden. Als Leistungsindikator bieten sich insbesondere Größen an, die unmittelbar am Akkumulatorelement gemessen werden können, d.h. Strom, Spannung, Temperatur bzw. Kombinationen hiervor, die die Leistung des Elements angeben, beispielsweise der Innenwiderstand als Quotient von Spannung und Strom, oder andere Werte, die beispielsweise den Strom und/oder die Spannung zu der Temperatur in Verhältnis setzen. Beispielsweise ergibt sich ein Leistungsindikator aus der Betrachtung einer Temperatur, wobei besonders hohe Temperaturen bei ansonsten vergleichbaren Strömen oder Spannungen bzw. Innenwiderständen auf einen vergleichsweise kleinen Leistungsindikator schließen lassen. Der Leistungsindikator kann eine unmittelbar zu erfassende Größe darstellen, eine physikalische Größe des Akkumulatorelements, das sich aus den gemessenen Größen ergibt, beispielsweise der Innenwiderstand, oder kann ein Parameter sein, der keine unmittelbare Entsprechung zu einer physikalischen Größe aufweist, jedoch gemessene Größen und/oder daraus abgeleitete Größen kombiniert und für die Leistung des Akkumulatorelements signifikant ist. Ein Beispiel hierfür ist eine Kombination aus Innenwiderstand, Zellspannung und Temperatur, beispielsweise als Produkt oder als Summe zugehöriger Werte, die frei von physikalischen Einheiten sind, so dass sich ein kombinierter Leistungsindikator ergibt, der ansteigt mit sich verringernder Zellenspannung, sich erhöhender Temperatur und mit ansteigendem Innenwiderstand. Aus dieser Kombination können eine oder mehrere Größen gestrichen werden, wobei die Kombination nicht nur durch Grundrechenarten, sondern durch allgemeine mathematische Kombinationen, beispielsweise durch eine Extrapolation oder eine polynomiale Näherung miteinander verknüpft werden können. Ein derartiger Leistungsindikator gibt somit nicht unmittelbar eine fließende elektrische Leistung an, sondern gibt an, welche Gesamtkapazität, welche noch verbleibende Ladung oder welche Traktionsleistung das betreffende Akkumulatorelement zur Traktion noch beisteuern kann.

Aus den Leistungsindikatoren, die für jedes Akkumulatorelement erfasst werden, beispielsweise anhand der Zellenspannung, wird eine Menge der kleinsten Leistungsindikatoren aller erfassten Leistungsindikatoren aller Akkumulatorelemente ermittelt. Die Menge kann vorgesehen sein durch ein einzelnes Element, d.h. durch den kleinsten Leistungsindikator aller erfassten Leistungsindikatoren oder durch eine Untergruppe der kleinsten Leistungsindikatoren aller Leistungsindikatoren der Akkumulatorelemente. Die Untergruppe kann beispielsweise gebildet werden durch die zwei kleinsten oder j-kleinsten Leistungsindikatoren, wobei j kleiner als die Anzahl der Akkumulatorelemente ist, oder durch alle Leistungsindikatoren, die kleiner als ein vorbestimmter Schwellwert sind, beispielsweise alle Zellenspannungen, die kleiner als 2,8 V sind. Somit wird nicht nur das kleinste Leistungselement, sondern eine Gruppe der kleinsten Leistungsindikatoren berücksichtigt. Bei einer besonders vereinfachten Ausführungsform wird nur der kleinste Leistungsindikator erfasst, und nur das zugehörige (d.h. schwächste) Akkumulatorelement wird zur Berechnung der maximal abrufbaren Leistung verwendet, d.h. durch Extrapolation anhand der Leistungsabgabegrenze dieses Akkumulatorelements mit dem kleinsten Leistungsindikator durch Extrapolation auf alle Akkumulatorelemente des Systems.

Zu dieser Menge (d.h. ein oder mehrere kleinste Leistungsindikatoren aller Leistungsindikatoren) wird eine Leistungsabgabegrenze vorgesehen, insbesondere durch Schätzung oder Näherung mittels eines Modells. Eine derartige Schätzung oder Näherung mittels eines Modells umfasst auch ein empirisches Modell, beispielsweise in Form einer Look-Up-Tabelle, welche beispielsweise eine Zellenspannung auf einen Wert einer Leistungsabgabe abbildet. Die Leistungsabgabegrenze kann vorgesehen sein durch eine elektrische Leistung, die das zugehörige Akkumulatorelement maximal noch erbringen kann, ohne Schaden zu nehmen, durch einen Maximalstrom, der das Akkumulatorelement ohne Schaden noch leisten kann, und/oder durch einen Energiebetrag, der aus dem Akkumulatorelement noch entnommen werden kann, ohne dass dieser Schaden nimmt. Eine Ausführungsform sieht somit vor, dass anhand eines mittelbar oder unmittelbar erfassten Leistungsindikatorwerts eine Leistungsabgabegrenze für das Akkumulatorelement mit dem kleinsten Leistungsindikator oder für die Akkumulatorelemente der Menge der kleinsten Leistungsindikatoren vorgesehen wird, oder Leistungsabgabegrenzen für jedes Akkumulatorelement vorgesehen werden, das einen Leistungsindikator aufweist, der der Menge der kleinsten Leistungsindikatoren angehört. Die Leistungsabgabegrenze kann vorgesehen werden alleine anhand der Leistungsindikatoren selbst, anhand weiterer gemessener physikalischer Momentangrößen des Akkumulatorelements oder anhand von abgeleiteten Größen, die den aktuellen Zustand des betreffenden Akkumulatorelements wiedergeben. Die Leistungsabgabegrenze kann somit nicht nur auf den physikalischen Größen fußen, auf denen die Leistungsindikatoren basieren, sondern kann neben den für die Leistungsindikatoren relevanten Größen auch weitere Größen umfassen. Beispielsweise kann ein Leistungsindikator alleine durch eine gemessene Zellenspannung vorgesehen sein, wobei sich die Leistungsabgabegrenze beispielsweise anhand dieser Zellspannung ergibt, in Kombination mit der gemessenen Temperatur oder in Kombination mit einem aus Messgrößen oder aus einem Modell abgeleiteten Widerstand. Weitere Größen, auf denen die

Leistungsabgabegrenze basieren kann, sind Ladezustand, aktuelle Leistungsfähigkeit oder andere Größen, die ermittelt oder geschätzt werden, beispielsweise mittels eines Modells. Vorzugsweise wird lediglich für die Akkumulatorelemente ein Modell vorgesehen, die den kleinsten Leistungsindikator aufweisen, so dass sich der Rechenaufwand deutlich vereinfacht.

Anhand dieser Leistungsabgabegrenze wird die maximal abrufbare Leistung des gesamten Traktions-Akkumulatorsystems extrapoliert. Die Extrapolation kann beispielsweise eine bloße Multiplikation mit der Anzahl der Zellen sein, oder eine Abbildung der Leistungsabgabegrenze bzw. -grenzen, die für eine Gruppe von schwachen Akkumulatorelementen stehen, auf die gesamte Serienschaltung des Akkumulatorsystems. Aufgrund der Extrapolation und insbesondere durch die Serienschaltung kann die maximal abrufbare Leistung des Gesamtsystems anhand der Leistungsabgabegrenze berechnet werden, die nur für ein oder für wenige Akkumulatorelemente gilt. Da aufgrund der Serienschaltung der Strom durch das schwächste Glied (d.h. durch den kleinsten maximal zulässigen Strom) definiert ist, kann die Extrapolation durch einfache Mittel vorgesehen werden. Gemäß weiteren Ausführungsformen wird bei der Extrapolation beispielsweise der Innenwiderstand einer Vielzahl oder aller Akkumulatorelemente berücksichtigt bzw. die Zellenspannung, um bei einer prognostizierten Belastung auf die exakte Zellenspannung des Akkumulatorelements mit dem kleinsten Leistungsindikator schließen zu können, wobei Elemente bzw. Zellen mit einem geringen Innenwiderstand und einer hohen Zellenspannung sich zusätzlich negativ auf die Zellenspannung des Akkumulatorelements mit dem kleinsten Leistungsindikator niederschlagen können und diese Zellenspannung zusätzlich verringern können. Es wird somit Extrapolation als Orientierung anhand des kleinsten Leistungsindikators bzw. anhand der Leistungsabgabegrenze des Akkumulatorelements mit dem kleinsten Leistungsindikator vorgeschlagen, um von diesem auf die maximal abrufbare Leistung zu schließen. Da die Akkumulatorelemente, welche nicht den bzw. die kleinsten Leistungsindikator/en aufweisen, stärker belastet werden können, ohne Schaden zu nehmen, kann von diesen angenommen werden, dass durch die Extrapolation keine maximal abrufbare Leistung erstellt wird, die für diese schädlich sein kann. Gleichermaßen wird durch die Orientierung an der Leistungsabgabe, die mit dem kleinsten Leistungsindikator verknüpft ist, gewährleistet, dass auch das schwächste Glied in der Serienschaltung, d.h. das Akkumulatorelement (bzw. die Akkumulatorelemente) mit dem kleinsten Leistungsindikator (bzw. mit den kleinsten Leistungsindikatoren) keinen Schaden nimmt. Die Leistungsabgabegrenze gibt die Leistung des schwächsten Akkumulatorelements wieder, bei dem das schwächste Akkumulatorelement im Wesentlichen keinen Schaden nimmt und bei Überschreiten dieser Leistung ein wesentlicher Schaden auftritt. Da dieser Übergang kontinuierlich ist, wird als im Wesentlichen schädlich ein Schwellwert genommen, ab dem beispielsweise eine überdurchschnittliche Alterung oder eine Entladung über eine vorgegebene Grenze hinaus auftritt. Um einen Sicherheitsabstand bei der Extrapolation zu gewährleisten, wird vorzugsweise nicht die Leistungsabgabegrenze selbst als Orientierung zur Extrapolation genommen, sondern die Leistungsabgabegrenze abzüglich eines vordefinierten Betrags, der eine Sicherheitsmarge darstellt. Der Betrag kann beispielsweise vordefiniert sein durch einen vordefinierten Anteil der Leistungsabgabegrenze, beispielsweise 10 %, oder durch einen Spannungs-, Leistungs- oder Energiewert. Die so extrapolierte, maximal abrufbare Leistung wird in Form eines Werts ausgegeben.

Die Zuordnung zwischen Leistungsindikator und Leistungsabgabegrenze bzw. die Extrapolation kann vorgesehen werden, indem eine Belastung des Traktions-Akkumulatorsystems schrittweise oder kontinuierlich erhöht wird, bis ein Akkumulatorelement einen Leistungsindikator aufweist, der unter einer Grenze liegt. In dieser Ausführungsform wird die Extrapolation nicht als Berechnung vorgesehen, sondern eine Belastung des gesamten Traktions-Akkumulatorsystems bildet die Auswirkungen einer abgerufenen Leistung auf den Leistungsindikator oder auf die Leistungsabgabegrenze ab. Hierbei ist lediglich der kleinste Leistungsindikator aller Leistungsindikatoren relevant. In dieser Ausführungsform wird als Leistungsindikator die Zellenspannung herangezogen, wobei die Leistungsabgabegrenze die Leistung ist, welche das Akkumulatorelement mit dem kleinsten Leistungsindikator (Zellenspannung entspricht einem unteren Grenzwert) abgibt. Die Leistungsabgabegrenze orientiert sich in diesem Fall an einer Zellenspannung als Leistungsindikator, wobei die kleinste Zellspannung, d.h. das schwächste Akkumulatorelement, die Leistungsabgabegrenze als die Leistung vorsieht, die von diesem Element abgegeben wird, wenn der kleinste Leistungsindikator eine Grenze erreicht.

Daher wird die Leistungsabgabegrenze vorgesehen durch Betreiben des Akkumulatorsystems an der Leistungsabgabegrenze eines Akkumulators, wobei diese umfasst: Belasten des gesamten Akkumulatorsystems, wobei das Akkumulatorelement an der Leistungsabgabegrenze betrieben wird, oder Betreiben nur des Akkumulatorelements mit einer Leistung, die der Leistungsabgabegrenze entspricht. Das Betreiben des Akkumulators an der Leistungsabgabegrenze umfasst das Verändern, insbesondere das Erhöhen der abgerufenen Leistung, beispielsweise durch Erhöhen eines Entladestroms, bis der kleinste Leistungsindikator einen Schwellwert erreicht hat. Dieser Schwellwert entspricht der Leistungsabgabegrenze, deren Überschreiten eine Beschädigung des schwächsten Akkumulatorelements mit sich bringt. Das Erhöhen der Belastung kann vorgesehen werden durch eine schrittweise Erhöhung, insbesondere durch eine iterative Erhöhung, bei der die Schrittweite von einem Abstand zwischen gemessenem Leistungsindikator und Schwellwert abhängt, oder gleichermaßen von der tatsächlich abgegebenen Leistung des Akkumulatorelements mit dem kleinsten Leistungsindikator und der Leistungsabgabegrenze.

Insbesondere sieht das Verfahren vor, das Akkumulatorsystem insgesamt mit einer konstant entnommenen Leistung zu belasten, um den sich ergebenden Spannungsverlauf aller Zellen in Abhängigkeit der Zeit zu ermitteln. Die maximal abrufbare Leistung ergibt sich aus dem Produkt des Stromverlaufs bzw. des Strombetrags, bei dem die Leistungsabgabegrenze des Akkumulatorelements mit dem kleinsten Leistungsindikator angetroffen wurde und der Summe der Spannungsverläufe bzw. der zugehörigen Spannungen aller Akkumulatorelemente, die bei diesem Strom von den Akkumulatorelementen vorgesehen wurden. Bei dem Betreiben des Akkumulatorsystems wird dieses vorzugsweise nur unterhalb der Leistungsabgabegrenze betrieben, und die Belastung wird verringert, wenn die Leistungsabgabegrenze des Akkumulatorelements mit dem kleinsten Leistungsindikator die Leistungsabgabegrenze abzüglich des vordefinierten Betrags erreicht.

Vorzugsweise umfasst das Ermitteln der Menge der kleinsten Leistungsindikatoren lediglich das Ermitteln des kleinsten Leistungsindikators, wobei die Menge durch diesen kleinsten Leistungsindikator vorgesehen wird. Die Leistungsabgabegrenze wird demnach ausgehend von diesem kleinsten Leistungsindikator vorgesehen. Die maximal abrufbare Leistung wird anhand der Leistungsabgabe des Akkumulatorelements mit dem kleinsten Leistungsindikator ausgeführt, so dass nur die Werte einer Zelle (d.h. der schwächsten Zelle) zur Extrapolation verwendet werden.

Der Leistungsindikator kann erfasst werden durch Erfassen einer Zellenspannung, die an den Akkumulatorelementen anliegt, Erfassen eines Belastungsstroms, mit dem das Traktions-Akkumulatorsystem beaufschlagt ist, beispielsweise während des Betreibens des Akkumulatorsystems an der Leistungsabgabegrenze. Das Erfassen kann ferner vorgesehen werden durch Erfassen einer Temperatur, die die Akkumulatorelemente aufweisen oder die das Akkumulatorelement mit dem kleinsten Leistungsindikator aufweist. Ferner kann der Leistungsindikator erfasst werden anhand eines Innenwiderstands, eines Ladezustands, einer Zellkapazität oder anderer Zustandsparameter der Akkumulatorelemente. Insbesondere kann eine Kombination dieser Größen als Leistungsindikator verwendet werden. Das Erfassen des Leistungsindikators umfasst daher das Messen von mindestens einer Betriebsgröße der Akkumulatorelemente, vorzugsweise während des Betreibens des Akkumulatorsystems an der Leistungsabgabegrenze. Als Betriebsgrößen werden vorzugsweise Strom, Spannung oder Temperatur gemessen. Das Erfassen kann ferner das Ermitteln des Leistungsindikators durch ein Modell umfassen, welches das Akkumulatorelement nachbildet. Bei der Erfassung des Leistungsindikators kann auch eine Messung mit einer ermittelten Größe kombiniert werden.

Vorzugsweise umfasst das Erfassen des Leistungsindikators ein mehrmaliges Erfassen des Leistungsindikators oder von Messgrößen, auf denen dieser basiert, bei unterschiedlichen Belastungsströmen, mit denen das Traktions-Akkumulatorsystem beaufschlagt wird, insbesondere während des Betreibens des Akkumulatorsystems an (jedoch vorzugsweise unterhalb) der Leistungsabgabegrenze. Die Belastungsströme werden vorzugsweise in steigender Reihenfolge vorgesehen, ausgehend von einem Belastungsstrom, bei dem davon ausgegangen werden kann, dass dieser keine Überschreitung einer Leistungsabgabegrenze eines Akkumulatorelements zur Folge hat. Der Belastungsstrom kann mehrfach, vorzugsweise schrittweise erhöht werden, wobei die Schrittweite entweder konstant ist oder insbesondere iterativ von dem Abstand zwischen tatsächlicher Leistung des Akkumulatorelements mit dem kleinsten Leistungsindikator und zugehöriger Leistungsabgabegrenze abhängt.

Gemäß einer weiteren Ausführung wird die Leistungsabgabegrenze vorgesehen durch Vergleich des Leistungsindikators mit einem vorgegebenen Minimalleistungsindikatorwert bzw. durch Differenzbildung zwischen erfasstem Leistungsindikator und Minimalleistungsindikatorwert. Ferner kann die Zellspannung oder die Zellspannungen als Leistungsindikator mit der Menge verglichen werden, insbesondere mit einer Minimalzellspannung als vorgegebener Minimalleistungsindikator. Die Minimalzellspannung hängt von dem Akkumulatortyp der Akkumulatorelemente ab. Die Minimalzellspannung ist um einen vorgegebenen Spannungsbetrag geringer als eine Normabgabespannung (die beispielsweise bei 100 % aufgeladenem Element vorliegt). Die Normabgabespannung, insbesondere der vorgegebene Spannungsbetrag, bzw. deren Differenz sind dadurch definiert, dass irreversible Schäden an den Akkumulatorelementen auftreten, wenn diese auf die Normabgabespannung abzüglich des Spannungsbetrags entladen werden. Bei Lithiumionenakkumulatoren ist die Normabgabespannung abzüglich des Spannungsbetrags beispielsweise 2,8 V, so dass der Minimalleistungsindikatorwert dieser Zellspannung entspricht.

Gemäß einer weiteren Ausführungsform wird die maximal abrufbare Leistung anhand der Leistungsabgabe des schwächsten oder der schwächsten Akkumulatorelemente extrapoliert, für die die Menge der kleinsten Leistungsindikatoren ermittelt wurde. Die maximal abrufbare Leistung des gesamten Traktions-Akkumulatorsystems wird unter der Vorgabe extrapoliert, dass die Leistungsabgabe des schwächsten Akkumulatorelements oder der schwächsten Akkumulatorelemente innerhalb eines Gesamtverbunds nicht größer als die Leistungsabgabegrenze abzüglich des vordefinierten Betrags ist. Als Gesamtverbund wird das Traktions-Akkumulatorsystem angesehen, welches alle Akkumulatorelemente umfasst. Diese Vorgabe zur Extrapolation berücksichtigt, dass das schwächste Glied, d.h. das Akkumulatorelement mit dem kleinsten Leistungsindikator (mit der kleinsten Zellspannung) nicht überlastet wird, so dass das schwächste Akkumulatorelement die Leistung bestimmt, die insgesamt abgegeben werden kann. Der Zusammenhang zwischen der Leistung, die von dem schwächsten Akkumulatorelement abgegeben werden kann, und der maximal abrufbaren Leistung der anderen Akkumulatorelemente ergibt sich durch die Serienschaltung, bei der das schwächste Glied die Maximalbelastung bestimmt, d.h. die maximal abzugebende Leistung bzw. den maximal abzugebenden Entladestrom. Hierbei wird nicht die Leistungsabgabegrenze selbst als Ziel vorgesehen, sondern die Leistungsabgabegrenze abzüglich eines vordefinierten Betrags, der größer als null ist und maximal einem Schutzabstand-Leistungsbetrag entspricht, der eine für alle Fälle ausreichende Schutzmarge wiedergibt, jedoch die maximal abrufbare Leistung unter Umständen über das Notwendige hinaus verringert.

Die maximal abrufbare Leistung wird als Strom gewertet oder als Produkt des Stromwerts und einer Gesamtspannung des Traktions-Akkumulatorsystems vorgesehen. Die Leistungsabgabe des schwächsten Akkumulatorelements oder der schwächsten Akkumulatorelemente wird durch die Zellspannung des schwächsten Akkumulatorelements (oder der Zellenspannungssumme der schwächsten Akkumulatorelemente) vorgesehen. Die Leistungsabgabegrenze wird durch einen vorgegebenen Mindestspannungsbetrag vorgesehen, der sich an der Zellspannung orientiert. Der Mindestspannungsbetrag entspricht der Spannung, deren Unterschreitung zu irreversiblen Schäden führt, wobei kein Akkumulatorelement des Akkumulatorsystems den Mindestspannungsbetrag unterschreitet. Der Schutzabstand-Leistungsbetrag kann ferner durch eine geschätzte Messfehlerstreuung bei der Zellspannungsmessung definiert werden, so dass auch bei unpräzisen Zellspannungsmessungen der Schutzabstand-Leistungsbetrag, d.h. der zusätzliche Spannungsbetrag, das Akkumulatorelement mit der geringsten Zellenspannung noch ausreichend vor irreversiblen Schäden schützt. Eine Ausführungsform wird ferner vorgesehen durch eine Vorrichtung zur Ermittlung, mit einer Spannungsvorrichtung, einer Strommessvorrichtung und einer Leistungserfassungsvorrichtung, die mit diesen Messvorrichtungen verbunden ist. Die Spannungsmessvorrichtung ist mit jedem Akkumulatorelement verbunden, um dessen Zellenspannung abzugreifen, und die Strommessvorrichtung ist vorgesehen, um den vom Akkumulatorsystem vorgesehenen Strom, d.h. den Entladestrom (oder auch den Ladestrom) zu erfassen. Die Leistungserfassungsvorrichtung erfasst anhand der Zellenspannung oder auch anhand der sich ergebenden Innenwiderstände (durch Quotient der Zellenspannung und erfassten Strom) für alle Akkumulatorelemente einen Leistungsindikator. Zumindest jedoch sieht die Leistungserfassungsvorrichtung für das Akkumulatorelement mit dem kleinsten Leistungsindikator, d.h. mit der geringsten Zellenspannung (oder auch mit der höchsten Temperatur) den Leistungsindikator vor. Eine Vergleichsvorrichtung ist mit der Leistungserfassungsvorrichtung verbunden und vergleicht die Leistungsindikatoren, um aus diesen den kleinsten Leistungsindikator zu ermitteln bzw. eine Menge der kleinsten Leistungsindikatoren.

Die Vorrichtung umfasst ferner eine Extrapolationsvorrichtung, die mit der Vergleichsvorrichtung verbunden ist, und die die Leistungsabgabegrenze des schwächsten Akkumulatorelements anhand des zugehörigen (d.h. kleinsten) Leistungsindikators extrapoliert, beispielsweise durch eine Abbildung anhand von Näherung eines Modells oder anhand von empirischen Daten. Insbesondere kann dies vorgesehen werden mittels einer einfachen Multiplikation der kleinsten Zellenspannung mit dem erfassten Strom. Während der Extrapolation wird berücksichtigt, dass die maximal abrufbare Leistung aufgrund der Serienschaltung der Akkumulatoren mit der Leistungsabgabe des schwächsten Akkumulatorelements verknüpft ist, wobei die Extrapolationsvorrichtung gemäß einer Vorgabe extrapoliert, die vorsieht, dass die maximal abrufbare Leistung des schwächsten Akkumulatorelements um einen vordefinierten Betrag (d.h. um eine Sicherheitsmarge) unter der Leistungsabgabegrenze liegt.

Die Vorrichtung kann ferner eine Temperaturmessvorrichtung umfassen, die die Temperaturen aller Akkumulatorelemente erfasst. Die Extrapolationseinrichtung kann ein Modell vorsehen, dass anhand des erfassten Stroms der erfassten Spannung und anhand der so erfassten Temperatur einen Betriebszustand des schwächsten Akkumulatorelements abschätzt. Der Betriebszustand kann wiedergegeben werden durch eine Kapazität, einen Ladezustand, einen Innenwiderstand oder eine Kombination hiervon, die das schwächste Akkumulatorelement aufweist.

Vorzugsweise ist die Vergleichsvorrichtung lediglich eingerichtet, um den kleinsten Leistungsindikator zu erfassen (und keine Mehrzahl von kleinsten Leistungsindikatoren). Gemäß dieser einfachen Ausführungsform ist die Extrapolationseinrichtung lediglich zur Extrapolation der Leistungsabgabe des schwächsten Akkumulatorelements eingerichtet. Zur weiteren Vereinfachung umfasst die Extrapolationseinrichtung im Wesentlichen eine Multiplikationseinrichtung, die die Leistungsabgabegrenze des schwächsten Akkumulatorelements mit der Anzahl der Akkumulatorelements des Systems multipliziert und das Produkt als maximal abrufbare Leistung abgibt.

### Kurze Beschreibung der Zeichnungen

- Die Figur 1: zeigt einen Zellspannungsverlauf gemäß dem Stand der Technik sowie die Auswirkungen des erfindungsgemäßen Verfahrens; und
- die Figur 2: zeigt einen Belastungsverlauf gemäß dem Stand der Technik sowie einen Belastungsverlauf gemäß dem erfindungsgemäßen Verfahren.

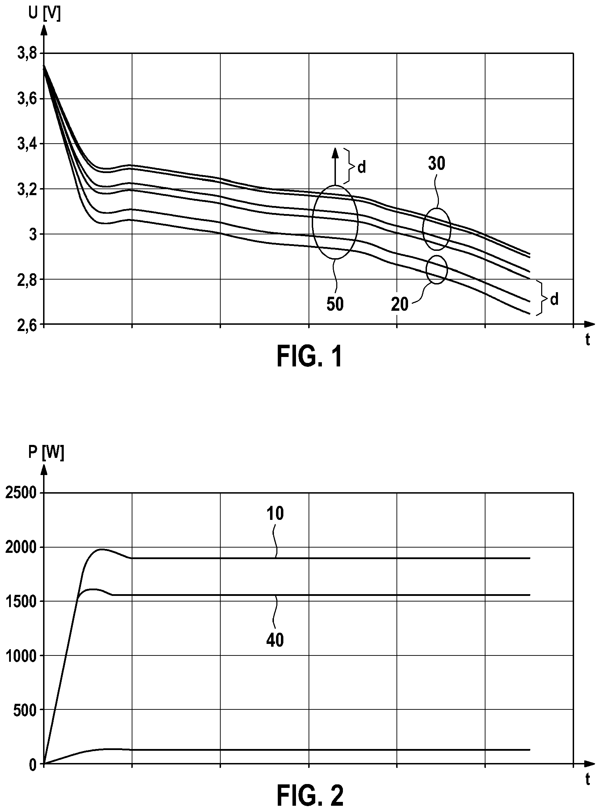

Die Figur 1 zeigt fünf unterschiedliche Zellspannungen in zeitlichem Verlauf bei einer Belastung, wie sie in Figur 2 vorgesehen ist. Zunächst entspricht der Spannungsverlauf der Belastung gemäß Kurve 10 der Figur 2. Durch die hohe Leistung fallen die beiden schwächsten Akkumulatorelemente in ihrer Zellspannung 20 unter einen Wert von 2,8 V, unterhalb dessen von einer dauerhaften Schädigung der Zellen bzw. einer erhöhten Alterung ausgegangen werden kann. Die anderen Zellen, welche aufgrund ihrer höheren Leistung einen Verlauf 30 haben, der über dem Verlauf 20 der schwächeren Zellen liegt, werden trotz der hohen Belastung gemäß Kurve 10 der Figur 2 nicht derart belastet, dass eine Schädigung bleibt, insbesondere da deren Spannungen über 2,8 V verbleiben. Da gemäß dem Stand der Technik der Durchschnitt aller Zellspannungen als Leistungsindikator verwendet wird, ergibt sich im Durchschnitt auch keine Zellspannung, die unter einem kritischen Wert von 2,8 V liegt, so dass eine maximal abrufbare Leistung gemäß dem Stand der Technik zulässig ist. Jedoch führt eine Unterschreitung der Grenzspannung von 2,8 V durch die Verläufe 20 zu einer sofortigen Abschaltung und Umgehung der entsprechenden Zellen, so dass sich ein deutlicher Verlust an Fahrkomfort ergibt.

Durch das Verfahren wird nicht der hier fehlleitende Mittelwert der Zellspannungen, sondern die minimalen Zellspannungen verwendet, die durch die Spannungsverläufe 20 dargestellt sind. Da zur Ermittlung der maximal abrufbaren Leistung nicht der Mittelwert, sondern die kleinsten Leistungsindikatoren (hier: die Zellspannung) verwendet werden, werden diese derart berücksichtigt, dass die maximal abrufbare Leistung des gesamten Akkumulatorsystems derart verringert vorgesehen wird, dass die kleinsten Leistungsindikatoren nicht den kritischen Wert von 2,8 V unterschreiten. Ein erfindungsgemäß vorgesehener Verlauf der maximal abrufbaren Leistung ergibt sich durch den Verlauf 40 der Figur 2, der insbesondere unterhalb des Verlaufs 10 liegt und der derart ausgestaltet ist, dass keine der Zellspannungen unter einem kritischen Wert von 2,8 V fällt. Insbesondere wird durch die Belastungen der Figur 2 der Zellspannungsverlauf derart verändert (verringert), dass dieser um einen Abstand d nach oben verschoben wird, so dass auch das schwächste Akkumulatorelement keine Zellspannung unterhalb der kritischen Spannung von 2,8 V aufweist. Insgesamt werden sämtliche Verläufe 50 der Figur 1 durch die erfindungsgemäß vorgesehene maximal abrufbare Leistung 40 nach oben verschoben, so dass das schwächste Elemente bzw. dessen Leistungsabgabegrenze, die sich bei 2,8 V der Zellenspannung ergibt, berücksichtig wird und nicht unterschritten wird.

Die Figur 2 zeigt einen Testverlauf von Abgabeleistungen, mit denen die Wirkungsweise des erfindungsgemäßen Verfahrens dargestellt werden kann, in Kombination mit den zugehörigen Zellspannungsverläufen der Figur 1. Der Verlauf 40, insbesondere der Wert während des konstanten Verlaufs (im eingeschwungenen Zustand) ist das Resultat der ermittelten maximal abrufbaren Leistung, die durch den konstanten Wert des Verlaufs 40 nach der Einschwingphase vorgesehen wird.

Das zu einem Verlauf nach Figur 1, um d angehoben führende Verfahren umfasst zunächst die Ermittlung, welches der Akkumulatorelemente den kleinsten Leistungsindikator aufweist. Der kleinste Leistungsindikator wird erfasst durch Vergleich der Zellspannungen, wobei die Leistungsindikatoren proportional oder identisch mit den Spannungswerten sind. Dieses Akkumulatorelement wird hinsichtlich der Leistungsabgabegrenze getestet, wobei die abgegebene Leistung bzw. ein Entladestrom so lange erhöht wird, bis die Leistungsabgabegrenze in Form des Erreichens einer kritischen Zellspannung von 2,8 V erreicht wird. Aus dem zugehörigen Strom und der so (knapp) erreichten Grenzspannung lässt sich durch Multiplikation die maximal mögliche Leistungsabgabe des schwächsten Akkumulatorelements berechnen. Anhand dieser Leistungsabgabe des einzelnen, kleinsten Akkumulatorelements wird die Gesamtleistung des gesamten Systems hochgerechnet, mit der Vorgabe, dass alle Akkumulatorelemente mit einer Abgabeleistung bzw. mit einem Abgabestrom betrieben werden, die bzw. der der maximal möglichen Leistungsabgabe des schwächsten Akkumulatorelements entspricht.

Eine Fahrsteuerung kann dann vorsehen, dass eine Begrenzung dann in Kraft tritt, wenn eine Leistung größer als die maximal abrufbare Leistung angefordert wird, um so das schwächste Element bzw. die schwächeren Elemente vor einer zu hohen Leistungsabgabe zu schützen.

## Patentansprüche

1. Verfahren zur Ermittlung der maximal abrufbaren Leistung eines Traktions-Akkumulatorsystems, das eine Vielzahl in Serienschaltung vorgesehener Akkumulatorelementen umfasst, mit den Schritten:
Erfassen mindestens eines Leistungsindikators für jedes Akkumulatorelement;
Ermitteln des kleinsten Leistungsindikators aller erfassten Leistungsindikatoren aller Akkumulatorelemente;
Vorsehen einer Leistungsabgabegrenze für das Akkumulatorelement mit dem kleinsten Leistungsindikator durch Betreiben des Akkumulatorsystems an der Leistungsabgabegrenze eines Akkumulatorelements, durch Schätzung oder durch Näherung mittels eines Modells, das das betreffende Akkumulatorenelement wiedergibt, ausgehend vom kleinsten Leistungsindikator und/oder anderen gemessenen physikalischen Momentangrößen des betreffenden Akkumulatorenelements;
**gekennzeichnet durch**
Extrapolieren der maximal abrufbaren Leistung des Traktions-Akkumulatorsystems anhand der Leistungsabgabegrenze durch Multiplikation der Leistungsabgabegrenze abzüglich eines vordefinierten Betrages mit der Vielzahl in Serienschaltung vorgesehener Akkumulatorelemente, wobei die maximal abrufbare Leistung des Traktions-Akkumulatorsystems durch die Extrapolation und aufgrund der Serienschaltung mit einer Leistungsabgabe des einen Akkumulatorelements, für das der kleinste Leistungsindikator ermittelt wurde, verknüpft ist; und
Ausgeben der maximal abrufbaren Leistung in Form eines Werts.

2. Verfahren nach dem vorangehenden Anspruch, wobei das Erfassen des Leistungsindikators umfasst: Erfassen einer Zellenspannung, die an den Akkumulatorelementen anliegt, eines Belastungsstroms mit dem das Traktions-Akkumulatorsystem beaufschlagt ist, einer Temperatur, die die Akkumulatorelemente aufweisen, eines Innenwiderstands der Akkumulatorelemente, eines Ladezustands, einer Zellkapazität oder eine Kombination hiervon, als Leistungsindikator, wobei das Erfassen umfasst: Messen von mindestens einer Betriebsgröße der Akkumulatorelemente, wobei die Betriebsgröße Strom, Spannung oder Temperatur ist, und/oder Ermitteln des Leistungsindikators durch ein Modell, das das Akkumulatorelement nachbildet.

3. Verfahren nach einem der vorangehenden Ansprüche, wobei das Erfassen umfasst: mehrmaliges Erfassen des Leistungsindikators bei unterschiedlichen Belastungsströmen, mit denen das Traktions-Akkumulatorsystem beaufschlagt wird oder durch mehrfaches, schrittweises Erhöhen des Belastungsstroms und Erfassen des Leistungsindikators für jeden schrittweise erhöhten Belastungsstrom.

4. Verfahren nach einem der vorangehenden Ansprüche, wobei die Leistungsabgabegrenze vorgesehen wird durch Vergleich des Leistungsindikators mit einem vorgegebenen Minimalleistungsindikatorwert bzw. durch Differenzbildung zwischen erfasstem Leistungsindikator und Minimalleistungsindikatorwert, oder durch Vergleich der Zellspannung als Leistungsindikator des Akkumulatorelements mit dem kleinsten Leistungsindikator mit einer Minimalzellspannung als vorgegebenem Minimalleistungsindikator, wobei die Minimalzellspannung von dem Akkumulatortyp der Akkumulatorelemente abhängt und um einen vorgegebenen Spannungsbetrag geringer als eine Normabgabespannung liegt, und wobei irreversible Schäden an den Akkumulatorelementen auftreten, wenn diese auf die Normabgabespannung abzüglich des Spannungsbetrags entladen werden.

5. Verfahren nach einem der vorangehenden Ansprüche, wobei das Extrapolieren umfasst: Extrapolieren der maximal abrufbare Leistung anhand der Leistungsabgabe des schwächsten Akkumulatorelements, für das der kleinsten Leistungsindikator ermittelt wurde, wobei das Extrapolieren die maximal abrufbare Leistung des gesamten Traktions-Akkumulatorsystems unter der Vorgabe extrapoliert, dass die Leistungsabgabe des schwächsten Akkumulatorelements innerhalb eines als das Traktions-Akkumulatorsystem vorgesehenen Gesamtverbunds, der alle Akkumulatorelemente umfasst, nicht größer als die Leistungsabgabegrenze abzüglich des vordefinierten Betrags ist, wobei der vordefinierten Betrags größer als null ist und maximal einem Schutzabstand-Leistungsbetrag entspricht.

6. Verfahren nach Anspruch 5, wobei die maximal abrufbare Leistung als Stromwert oder als Produkt des Stromwerts und einer Gesamtspannung des Traktions-Akkumulatorsystems vorgesehen ist, die Leistungsabgabe des schwächsten Akkumulatorelements durch die Zellenspannung des schwächsten Akkumulatorelements vorgesehen ist, die Leistungsabgabegrenze durch einen vorgegebenen Mindestspannungsbetrag vorgesehen ist, der zur Vermeidung von irreversiblen Schäden von keinem Akkumulatorelement unterschritten werden soll, und der Schutzabstand-Leistungsbetrag durch einen zusätzlichen Spannungsbetrag vorgesehen wird, der einer Sicherheitsspanne entspricht, die insbesondere durch eine geschätzte Messfehlerstreuung bei der Zellspannungsmessung definiert ist.

7. Vorrichtung zur Ermittlung der maximal abrufbaren Leistung eines Traktions-Akkumulatorsystems, das eine Vielzahl in Serienschaltung vorgesehener Akkumulatorelementen umfasst, umfassend:
eine Spannungsmessvorrichtung, die mit jedem Akkumulatorelement verbunden ist und zur Erfassung der an dem Akkumulatorelement anliegenden Spannung eingerichtet ist;
eine Strommessvorrichtung, die mit dem Traktions-Akkumulatorsystem verbunden ist und eingerichtet ist, einen von dem Traktions-Akkumulatorsystem abgegebenen Strom zu erfassen;
eine mit diesen Messvorrichtungen verbundene Leistungserfassungsvorrichtung, die eingerichtet ist, anhand der an den Akkumulatorelementen jeweils anliegenden Spannung oder anhand von Innenwiderständen der Akkumulatorelemente, die sich aus dieser Spannung und dem abgegebenen Strom ergeben, für alle Akkumulatorelemente einen Leistungsindikator vorzusehen oder zumindest für das Akkumulatorelement mit dem kleinsten Leistungsindikator den Leistungsindikator vorzusehen;
eine Vergleichsvorrichtung, die mit der Leistungserfassungsvorrichtung verbunden ist, und eingerichtet ist, die Leistungsindikatoren zu vergleichen und den kleinsten Leistungsindikator zu ermitteln; und eine Extrapolationsvorrichtung, die mit der Vergleichsvorrichtung verbunden ist, und die eingerichtet ist, die Leistungsabgabegrenze des Akkumulatorelements mit dem kleinsten Leistungsindikator anhand dieses kleinsten Leistungsindikators zu extrapolieren, und die ferner eingerichtet ist, anhand dieser Leistungsabgabegrenze die maximal abrufbare Leistung gemäß der Vorgabe zu extrapolieren, dass die maximal abrufbare Leistung durch die Serienschaltung aller Akkumulatorelemente mit einer Leistungsabgabe des Akkumulatorelements, das den kleinsten Leistungsindikator aufweist, verknüpft ist, und die Extrapolationseinrichtung ferner eine Multiplikationseinrichtung umfasst,
**dadurch gekennzeichnet, dass**
die Extrapolationseinrichtung eingerichtet ist, anhand der Leistungsabgabegrenze des Akkumulatorelements mit dem kleinsten Leistungsindikator mittels der Multiplikationseinrichtung die maximal abrufbare Leistung als Produkt der Leistungsabgabegrenze abzüglich eines vordefinierten Betrags und der Anzahl der Akkumulatorenelemente in dem Akkumulatorsystem zu errechnen.

8. Vorrichtung nach Anspruch 7, die ferner eine Temperaturmessvorrichtung umfasst, die mit der Extrapolationseinrichtung verbunden und eingerichtet ist, die Temperatur der Akkumulatorelemente zu erfassen, wobei die Extrapolationseinrichtung ein Modell umfasst, das anhand des erfassten Stroms, der erfassten Spannung und anhand der erfassten Temperatur einen Betriebszustand zumindest des Akkumulatorelements mit dem kleinsten Leistungsindikator zu schätzen, wobei der Betriebszustand durch eine Kapazität, einen Ladezustand und/oder einen Innenwiderstand des Akkumulatorelements wiedergegeben ist.

## Claims

1. Method for determining the maximum obtainable power of a rechargeable traction battery system that comprises a multiplicity of rechargeable battery elements connected in series, said method having the steps:
detecting at least one power indicator for each rechargeable battery element;
determining the smallest power indicator of all the detected power indicators of all the rechargeable battery elements;
providing a power output limit for the rechargeable battery element having the smallest power indicator by operating the rechargeable battery system at the power output limit of a rechargeable battery element, by estimation or by approximation by means of a model that represents the relevant rechargeable battery element, starting from the smallest power indicator and/or other measured physical instantaneous variables of the relevant rechargeable battery element;
**characterized by**
extrapolating the maximum obtainable power of the rechargeable traction battery system based on the power output limit by multiplying the power output limit minus a predefined absolute value by the multiplicity of rechargeable battery elements connected in series, wherein the maximum obtainable power of the rechargeable traction battery system is related, by the extrapolation and on account of the series connection, to a power output of the one rechargeable battery element for which the smallest power indicator has been determined; and
outputting the maximum obtainable power in the form of a value.

2. Method according to the preceding claim, wherein the detection of the power indicator comprises: detecting, as power indicator, a cell voltage that is supplied to the rechargeable battery elements, a load current that is supplied to the rechargeable traction battery system, a temperature that the rechargeable battery elements exhibit, an internal resistance of the rechargeable battery elements, a state of charge, a cell capacity or a combination thereof, wherein the detection comprises: measuring at least one operating variable of the rechargeable battery elements, wherein the operating variable is current, voltage or temperature, and/or detecting the power indicator by a model that reproduces the rechargeable battery element.

3. Method according to either of the preceding claims, wherein the detection comprises: repeatedly detecting the power indicator at different load currents that are supplied to the rechargeable traction battery system or by repeatedly increasing the load current incrementally and detecting the power indicator for each incrementally increased load current.

4. Method according to one of the preceding claims, wherein the power output limit is provided by comparing the power indicator with a prescribed minimum power indicator value or by forming the difference between the detected power indicator and the minimum power indicator value, or by comparing the cell voltage as power indicator of the rechargeable battery element having the smallest power indicator with a minimum cell voltage as prescribed minimum power indicator, wherein the minimum cell voltage depends on the rechargeable battery type of the rechargeable battery elements and is lower than a standard output voltage by a prescribed absolute voltage value, and wherein there is irreversible damage to the rechargeable battery elements when said rechargeable battery elements are discharged to the standard output voltage minus the absolute voltage value.

5. Method according to one of the preceding claims, wherein the extrapolation comprises: extrapolating the maximum obtainable power based on the power output of the weakest rechargeable battery element for which the smallest power indicator has been determined, wherein the extrapolation extrapolates the maximum obtainable power of the entire rechargeable traction battery system under the condition that the power output of the weakest rechargeable battery element within a composite system that is provided as the rechargeable traction battery system and that comprises all the rechargeable battery elements is not greater than the power output limit minus the predefined absolute value, wherein the predefined absolute value is greater than zero and at a maximum corresponds to a protective distance absolute power value.

6. Method according to Claim 5, wherein the maximum obtainable power is provided as a current value or as a product of the current value and a total voltage of the rechargeable traction battery system, the power output of the weakest rechargeable battery element is provided by the cell voltage of the weakest rechargeable battery element, the power output limit is provided by a prescribed minimum absolute voltage value, which, in order to prevent irreversible damage, should not be undershot by any rechargeable battery element, and the protective distance absolute power value is provided by an additional absolute voltage value, which corresponds to a safety period that is defined, in particular, by an estimated measurement error distribution during the cell voltage measurement.

7. Apparatus for determining the maximum obtainable power of a rechargeable traction battery system that comprises a multiplicity of rechargeable battery elements connected in series, comprising:
a voltage measurement apparatus, which is connected to each rechargeable battery element and is configured to detect the voltage that is supplied to the rechargeable battery element;
a current measurement apparatus, which is connected to the rechargeable traction battery system and is configured to detect a current that is output by the rechargeable traction battery system;
a power detection apparatus that is connected to said measurement apparatuses, said power detection apparatus being configured, based on the voltage that is supplied to the respective rechargeable battery elements or based on internal resistances of the rechargeable battery elements that result from said voltage and the output current, to provide a power indicator for all the rechargeable battery elements or to provide the power indicator at least for the rechargeable battery element having the smallest power indicator;
a comparison apparatus, which is connected to the power detection apparatus and is configured to compare the power indicators and to determine the smallest power indicator; and
an extrapolation apparatus, which is connected to the comparison apparatus and is configured to extrapolate the power output limit of the rechargeable battery element having the smallest power indicator based on said smallest power indicator, and which is further configured, based on said power output limit, to extrapolate the maximum obtainable power under the condition that the maximum obtainable power is related to a power output of the rechargeable battery element having the smallest power indicator by the series connection of all the rechargeable battery elements, and the extrapolation device further comprises a multiplication device,
**characterized in that**
the extrapolation device is configured, based on the power output limit of the rechargeable battery element having the smallest power indicator, to calculate, by means of the multiplication device, the maximum obtainable power as a product of the power output limit minus a predefined absolute value and the number of rechargeable battery elements in the rechargeable battery system.

8. Apparatus according to Claim 7, which further comprises a temperature measurement apparatus, which is connected to the extrapolation device and is configured to detect the temperature of the rechargeable battery elements, wherein the extrapolation device comprises a model, which, based on the detected current, the detected voltage and based on the detected temperature, to estimate an operating state at least of the rechargeable battery element having the smallest power indicator, wherein the operating state is represented by a capacitance, a state of charge and/or an internal resistance of the rechargeable battery element.

## Revendications

1. Procédé de détermination de la puissance maximale disponible d'un système accumulateur de traction, comprenant une pluralité d'éléments d'accumulateur montés en série, comprenant les étapes consistant à :
détecter au moins un indicateur de puissance pour chaque élément d'accumulateur ;
déterminer le plus petit indicateur de puissance de tous les indicateurs de puissance détectés de tous les éléments d'accumulateur ;
définir une limite de puissance de sortie pour l'élément d'accumulateur ayant l'indicateur de puissance le plus petit par mise en fonctionnement du système d'accumulateur à la limite de puissance de sortie d'un élément d'accumulateur, en estimant ou en déterminant une approximation au moyen d'un modèle qui reproduit l'élément d'accumulateur concerné, à partir de l'indicateur de puissance le plus petit et/ou d'autres grandeurs physiques instantanées mesurées de l'élément d'accumulateur concerné ;
**caractérisé par** les étapes consistant à
extrapoler la puissance maximale disponible du système accumulateur de traction sur la base de la limite de puissance de sortie en multipliant la limite de puissance de sortie, déduction faite d'une valeur prédéfinie pour la pluralité d'éléments d'accumulateur montés en série, dans lequel la puissance maximale disponible du système accumulateur de traction est combinée au travers de l'extrapolation et sur la base de la connexion en série à une puissance de sortie dudit élément d'accumulateur pour lequel l'indicateur de puissance le plus petit a été déterminé ; et
fournir en sortie la puissance maximale disponible sous la forme d'une valeur.

2. Procédé selon la revendication précédente, dans lequel la détection de l'indication de puissance consiste à : détecter une tension de cellule qui est appliquée à l'élément d'accumulateur, un courant de charge auquel est soumis le système accumulateur de traction, une température des éléments d'accumulateur, une résistance interne des éléments d'accumulateur, un état de charge, une capacité de cellule, ou une combinaison de ceux-ci, en tant qu'indicateur de puissance, dans lequel la détection consiste à : mesurer au moins une grandeur de fonctionnement des éléments d'accumulateur, dans lequel la grandeur de fonctionnement est un courant, une tension ou une température, et/ou déterminer l'indicateur de puissance au moyen d'un modèle qui reproduit l'élément d'accumulateur.

3. Procédé selon l'une quelconque des revendications précédentes, dans lequel la détection consisté à : détecter plusieurs fois l'indicateur de puissance pour des courants de charge différents auxquels est soumis le système accumulateur de traction ou en augmentant plusieurs fois pas à pas le courant de charge et en détectant l'indicateur de puissance pour chaque courant de charge augmenté pas à pas.

4. Procédé selon l'une quelconque des revendications précédentes, dans lequel la limite de puissance de sortie est définie par comparaison de l'indicateur de puissance à une valeur d'indicateur de puissance minimale prédéterminée ou par calcul d'une différence entre l'indicateur de puissance détecté et la valeur minimale de l'indicateur de puissance, ou par comparaison de la tension de cellule, en tant qu'indicateur de puissance de l'élément d'accumulateur ayant l'indicateur de puissance le plus petit, à une tension de cellule minimale en tant qu'indicateur de puissance minimale prédéterminée, dans lequel la tension de cellule minimale dépend du type d'accumulateur des éléments d'accumulateur et est inférieure à une tension de sortie normalisée d'une valeur de tension prédéterminée, et dans lequel des dommages irréversibles des éléments se produisent lorsque ceux-ci se déchargent à la tension de sortie normalisée déduction faite de la valeur de la tension.

5. Procédé selon l'une quelconque des revendications précédentes, dans lequel l'extrapolation consiste à : extrapoler la puissance maximale disponible sur la base de la puissance de sortie de l'élément d'accumulateur le plus faible pour lequel l'indicateur de puissance le plus petit a été déterminé, dans lequel l'extrapolation consiste à extrapoler la puissance maximale disponible de l'ensemble du système accumulateur de traction en faisant l'hypothèse que la puissance de sortie de l'élément d'accumulateur le plus faible au sein d'un ensemble monobloc prévu en tant que système accumulateur de traction comprenant les éléments d'accumulateur, n'est pas supérieure à la limite de puissance de sortie déduction faite de ladite valeur prédéfinie, dans lequel la valeur prédéfinie est supérieure à zéro et correspond au maximum à une valeur de puissance de distance de sécurité.

6. Procédé selon la revendication 5, dans lequel la puissance maximale disponible est définie comme étant une valeur de courant ou comme étant un produit de la valeur de courant par une tension totale du système accumulateur de traction, la puissance de sortie de l'élément d'accumulateur le plus faible est définie par la tension de cellule de l'élément d'accumulateur le plus faible, la limite de puissance de sortie est définie par une valeur de tension minimale prédéterminée qui ne doit être dépassée en sens décroissant par aucun élément d'accumulateur pour éviter des dommages irréversibles, et la valeur de puissance correspondant à la distance de sécurité est définie par une valeur de tension supplémentaire qui correspond à un intervalle de sécurité notamment défini par une dispersion estimée des erreurs de mesure lors de la mesure de la tension de cellule.

7. Dispositif de détermination de la puissance maximale disponible d'un système accumulateur de traction comprenant une pluralité d'éléments d'accumulateur montés en série, comprenant :
un dispositif de mesure de tension qui est relié à chaque élément d'accumulateur et est conçu pour détecter la tension appliquée à l'élément d'accumulateur ;
un dispositif de mesure de courant qui est relié au système accumulateur de traction et est conçu pour détecter un courant délivré par le système accumulateur de traction ;
un dispositif de détection de puissance relié auxdits dispositifs de mesure, qui est conçu pour définir, sur la base de la tension respectivement appliquée aux éléments d'accumulateur ou pour définir sur la base de résistances internes des éléments d'accumulateur qui résultent de ladite tension ou du courant délivré, pour tous les éléments d'accumulateur, un indicateur de puissance ou pour définir au moins l'indicateur de puissance correspondant à l'élément d'accumulateur ayant l'indicateur de puissance le plus petit ;
un dispositif de comparaison qui est relié au dispositif de détection de puissance et est conçu pour comparer les indicateurs de puissance et pour déterminer l'indicateur de puissance le plus petit ; et un dispositif d'extrapolation qui est relié au dispositif de comparaison et est conçu pour extrapoler la limite de puissance de sortie de l'élément d'accumulateur ayant l'indicateur de puissance le plus petit sur la base dudit indicateur de puissance le plus petit, et qui est en outre conçu pour extrapoler, sur la base de ladite limite de puissance de sortie, la puissance maximale disponible conformément à l'hypothèse selon laquelle la puissance maximale disponible est combinée par le circuit série de tous les éléments d'accumulateur à la puissance de sortie de l'élément d'accumulateur qui présente l'indicateur de puissance le plus petit, et le dispositif d'extrapolation comprend en outre un dispositif de multiplication,
**caractérisé en ce que**
le dispositif d'extrapolation est conçu pour calculer, sur la base de la limite de puissance de sortie de l'élément d'accumulateur ayant l'indicateur de puissance le plus petit au moyen du dispositif de multiplication, la puissance maximale disponible en tant que produit de la limite de puissance de sortie, déduction faite d'une valeur prédéfinie, par le nombre des éléments d'accumulateur dans le système accumulateur.

8. Dispositif selon la revendication 7, comprenant en outre un dispositif de mesure de température qui est relié au dispositif d'extrapolation et est conçu pour détecter la température des éléments d'accumulateur, dans lequel le dispositif d'extrapolation comprend un modèle qui pour estimer un état de fonctionnement d'au moins l'élément d'accumulateur ayant l'indicateur de puissance le plus petit sur la base du courant détecté, de la tension détectée, et sur la base de la température détectée, dans lequel l'état de fonctionnement est représenté par une capacité, un état de charge et/ou une résistance interne de l'élément d'accumulateur.
